# EUROPEAN PATENT APPLICATION

(11) **EP 4 583 169 A1**
(43) Date of publication of application: **09.07.2025**
(21) Application number: 24150538.7
(22) Date of filing: 05.01.2024
(51) Int. Cl.: H01L 33/00, H01L 33/12, H01L 33/32, H01L 21/02, H01L 29/20

(54) **SEMICONDUCTOR STRUCTURE, OPTOELECTRONIC DEVICE AND FABRICATION METHOD**

(71) Applicant: ALLOS Semiconductors GmbH, 01069 Dresden (DE)
(72) Inventor: Nishikawa, Atsushi, 01069 Dresden (DE); Lösing, Alexander, 48691 Vreden (DE)
(74) Representative: Eisenführ Speiser

(57) **Abstract**

The present invention relates to a method of fabricating a semiconductor structure. The method comprises:
- providing a hetero-substrate;
- epitaxially fabricating above the substrate a substantially strain-relaxed or unstrained GaN layer; and
- epitaxially fabricating an active layer structure above the GaN layer, the active layer structure extending along a stacking direction from a lower end face facing towards the substantially strain-relaxed or unstrained GaN layer to an upper end face opposite the lower end face.

At a distance that is between 200 nm above the substrate along the stacking direction and the upper end face of the active layer structure, the semiconductor structure has a nano pipe density of 0.1 µm⁻² or less, wherein a nano pipe density denotes a density of screw-type or mixed type dislocations having a hollow open core, herein called nano pipes. The present invention also relates to an optoelectronic device such comprising the semiconductor structure. Moreover, the present invention relates to a micro LED.

## Description

### TECHNICAL FIELD

The present invention relates to a method of fabricating a semiconductor structure and to a semiconductor structure. Furthermore, the present invention relates to an optoelectronic device comprising the semiconductor structure. The invention may be employed *inter alia* in the context of the fabrication of III-nitride compound semiconductor micro light-emitting diodes (LEDs), but also for other LEDs and laser diodes and for electronic devices such as high electron mobility transistor (HEMT) structures.

### BACKGROUND OF THE INVENTION

Group-III nitride (also referred to herein as "III-nitride") semiconductors are used in electronic and optoelectronic devices for commercial applications. Active epitaxial III-nitride layer structures in these devices need to be fabricated with high crystal quality. Due to the limited availability of substrates which are made of III-nitride semiconductors, the industry uses different other substrates for the epitaxial growth of III-nitride semiconductor layer structures.

Nano pipe-defects, hereinafter referred to as nano pipes, are known in the art as open core screw-type dislocations and have been found responsible for leakage currents in GaN based LEDs. In particular, nano pipes have been described as hollow tubes with nanometer scale diameters and {1-100} faceted sides, see O. Contreras, et al., "Termination of hollow core nanopipes in GaN by an AIN interlayer", Journal of Crystal Growth, Volume 455, 2016, Pages 43-48, ISSN 0022-0248, https://doi.org/10.1016/j.jcrysgro.2016.09.027. O. Contreras, *et al* suggest using an AIN interlayer to block nano pipes from propagating further. In particular, when present in an electronic or optoelectronic device, nano pipes may lead to poor device performance, for example, due to an increase of leakage currents, in particular, if nano pipes are present in an active layer structure of such a device.

It is thus desirable to provide a method for epitaxially fabricating a semiconductor structure with a particularly low density of nano pipes in its active layer structure, and a corresponding semiconductor structure achieving this goal. In particular, it would be desirable to avoid or at least reduce a formation of nano pipes in a semiconductor structure right from the beginning such that no further layers for blocking the propagation of nano pipes are required.

### SUMMARY OF THE INVENTION

It is an objective of the present invention to provide a method for epitaxially fabricating a III-nitride semiconductor structure with a particularly low density of nano pipes in its active layer structure that can be used for a wider range of hetero-substrates, i.e. for substrate materials without requiring a pre-structuring of the growth surface. The possibility of achieving this goal for Si substrates such as Si wafers would be particularly desirable, because they form an industry standard and promise to achieve a comparatively low cost per die.

According to the present invention, a method of fabricating a semiconductor structure is proposed. The method comprises:
- providing a hetero-substrate, hereinafter substrate;
- epitaxially fabricating above the substrate a substantially strain-relaxed or unstrained GaN layer; and
- epitaxially fabricating an active layer structure above the GaN layer, the active layer structure extending along a stacking direction from a lower end face facing towards the substantially strain-relaxed or unstrained GaN layer to an upper end face opposite the lower end face.

In the method, fabricating the semiconductor structure comprises that at a distance that is between 200 nm above the substrate along the stacking direction and the upper end face of the active layer structure, the semiconductor structure has a nano pipe density of 0.1 µm⁻² or less, wherein a nano pipe density denotes a density of screw-type or mixed type dislocations having a hollow open core, hereinafter called nano pipes. In other words, in the semiconductor structure, at an arbitrary (or random) distance that is between 200 nm above the substrate along the stacking direction and the upper end face of the active layer structure, an area of 1 µm² can be found, where a nano pipe density is 0.1 µm⁻² or less. Such an area of 1 µm² with a nano pipe density is 0.1 µm⁻² or less lies within a plane that is perpendicular to the stacking direction, i.e., for example, parallel to the substrate and/or the upper end face of the active layer structure.

The present invention provides a layer structure that allows achieving a particularly low nano pipe density within most of the volume of the semiconductor structure using epitaxial processing on a hetero-substrate, namely, a nano pipe density of 0.1 µm⁻² or less at a distance that is between 200 nm above the substrate along the stacking direction and the upper end face of the active layer structure. The lower limit of 200 nm is selected since it is well above the nucleation layers on the hetero-substrate. Herein, a hetero-substrate is to be understood as a substrate with another material than GaN at the surface. A hetero-substrate may be made of or may comprise a growth surface of sapphire, silicon carbide, or (most preferably) silicon. Correspondingly, herein, a homo-substrate is made of GaN, or is made of the material of the substantially strain-relaxed or unstrained GaN layer, at least at the surface.

The invention recognizes that a nano pipe density of 0.1 µm⁻² or less is to be achieved for the fabrication of an active III-nitride layer structure with high performance characteristics and low leakage currents. That is, the invention recognizes that a higher nano pipe density has been determined detrimental for the device performance characteristics, since it contributes to leakage currents in the device.

Achieving such a low nano pipe density of 0.1 µm⁻² or less can be achieved since the semiconductor structure has the substantially strain-relaxed or unstrained GaN layer. Due to the presence of the substantially strain-relaxed or unstrained GaN layer, the formation of nano pipes can be significantly reduced. In particular, due to the substantially strain-relaxed or unstrained GaN layer it is possible that the semiconductor structure has no nano pipes at all at a distance that is between 200 nm above the substrate along the stacking direction and the upper end face of the active layer structure. It is thus the substantially strain-relaxed or unstrained GaN layer that makes an additional layer for blocking nano pipe propagation as present in known devices obsolete. Thereby, it is possible to provide a semiconductor structure with a low nano pipe density of 0.1 µm⁻² or less in a volume extending between 200 nm above the substrate along the stacking direction and the upper end face of the active layer structure that is substantially free of nano pipes. Such low nano pipe densities in a semiconductor structure could not be achieved before with known approaches that generally rely on the presence of an additional layer for blocking nano pipes from propagating into an active layer structure.

The present invention thus further recognizes that, for meeting this low value of the upper threshold of the nano pipe density at a distance that is between 200 nm above the substrate along the stacking direction and the upper end face of the active layer structure in a growth process on a hetero-substrate, it is essential to fabricate the active layer structure on a substantially strain-relaxed or unstrained GaN layer.

Having a low nano pipe density of 0.1 µm⁻² or less is particularly advantageous for devices including one or more micro LEDs (sometimes also referred to as µLED, µ LED or mi-croLED). Herein, a micro LED is an LED that has a surface area of 400 µm² or less, in particular 100 µm² or less. Micro LEDs may have side lengths in the single digit micrometer range or less, and typically at most 20 µm. For example, a micro LED may have a quadratic surface area of 20 µm × 20 µm. A micro LED may also have a surface area of less than 1 µm². Sometimes a micro LED having a surface area of less than 1 µm² may also be referred to as nano LED. For example, a nano LED may have a surface area of, e.g., 800 nm² or less, 600 nm²or less 400 nm² or less or even 100 nm² or less. A lower limit for a nano LED may, for example, be 0.5 nm². For comparison, micro LEDs may have approximately 1/2500 the active surface area of a conventional LED, when assuming that a conventional LED has an active surface area of 1 × 1 mm² and a micro LED has an active surface area of 20 × 20 µm². Micro LEDs can have different quadratic, rectangular, round or any other shape. In a micro LED device, e.g., a micro LED display, each micro LED is driven to emit light.

The invention has thus recognized that the smaller an active surface area of a III-nitride semiconductor structure becomes, the more detrimental is the impact of even a low number of nano pipes in the active layer structure on the device performance characteristics. A similar amount of nano pipes distributed in the active layer of a larger LED may have a less significant impact on the device performance characteristics. However, for example for devices including micro LEDs as pixels in a display device, this may lead to non-operative dark pixels in the worst case.

In the case of LEDs or micro LEDs, the term performance characteristics may refer to an injection efficiency of charge carriers, i.e., the proportion of charge carriers passing through the device that are injected into the active layer structure. According to the current view of the inventor, with regard to a typical LED structure having the p-type layer arranged at the upper end of the layer structure, the injection efficiency of holes is particularly affected by the density of nano pipes at the upper end of the active layer structure. Another relevant performance characteristic that can be affected by the nano pipe density is the internal quantum efficiency, i.e., the proportion of radiative electron-hole recombination versus the total, radiative and non-radiative electron-hole recombination in the active region.

The invention thus teaches a method and a structure that allow achieving a nano pipe density of 0.1 µm⁻² or less at a distance that is between 200 nm above the substrate along the stacking direction and the upper end face of the active layer structure, including a method for fabricating an epiwafer, and including such an epiwafer with the claimed layer structure, which epiwafer may be an intermediate product during a fabrication process or may be offered for sale as a commercial intermediate product for further device fabrication.

Preferably, embodiments of the semiconductor structure of the invention in the form of an epiwafer, e.g., a GaN-on-Si epiwafer, exhibit an average nano pipe density of 0.01 µm⁻² or less, such as 0.001 µm⁻² or less or 0.0001 µm⁻² or less, wherein a reference area for these values of the average nano pipe density comprises at least 80 % of a total area of an upper surface of the epiwafer. A reference area of the at least 90 %, at least 95 % or 100 % of the total area of the upper surface of the epiwafer applies in further embodiments. This includes epiwafers with a lateral extension in at least one spatial direction of 100 mm or more, for instance in the preferred range of 100 mm to 450 mm, e.g., a circular epiwafer with a corresponding diameter.

Alternatively, e.g. to an epiwafer, the semiconductor structure may be an LED array comprising a plurality of LEDs, e.g., micro LEDs, that each are configured for emitting light under operation of a voltage. The LED array be part of a display or configured for being part of a display, e.g., a full array LED display such as an RGB full-array LED display. The LEDs may be controllable individually or in one or more groups. The active layer structure of the semiconductor structure configured as an LED array, preferably, is formed by the individual active layers of the plurality of LEDs. In other words, the individual active layers of the LEDs together form the active layer structure of the semiconductor structure, i.e., when adding up the individual active layers of the LEDs one obtains the active layer structure of the semiconductor structure. For example, considering a LED array comprising 1000 × 1000 pixels and each chip forming a pixel having an individual active layer of 4 µm⁻², the active layer structure of the LED array would add up to four million µm². Preferably, for such an LED array, and more specifically for the active layer structure of the LED array, an average nano pipe density is 0.01 µm⁻² or less, such as 0.001 µm⁻² or less or 0.0001 µm⁻² or less, wherein a reference area for these values of the average nano pipe density comprises at least 80 % of a total area of an upper surface of the active layer structure of the LED array. A reference area of the at least 90 %, at least 95 % or 100 % of the total area of the upper surface of active layer structure of the LED array applies in further embodiments.

When having an average nano pipe density is 0.01 µm⁻² or less, statistically one nano pipe or less may be present in case the total area is 100 µm². The table shown below exemplary depicts for different chip sizes from 1 µm² to 100 µm² and the assumption that an average nano pipe density is 0.01 µm⁻² or less, a percentage of nano pipe free chips.

| Chip size | Statistical number of nano pipe free chips (nano pipe density of 0.01 µm⁻² or less) | Statistical number of nano pipe free chips (nano pipe density of 0.001 µm⁻² or less) | Statistical number of nano pipe free chips (nano pipe density of 0.0001 µm⁻² or less) |
|---|---|---|---|
| 1 µm² | 99 % or more | 99.9 % or more | 99.99 % or more |
| 2 µm² | 98 % or more | 99.8 % or more | 99.98 % or more |
| 5 µm² | 95 % or more | 99.5 % or more | 99.95 % or more |
| 10 µm² | 90 % or more | 99.0 % or more | 99.90 % or more |
| 25 µm² | 75 % or more | 97.5 % or more | 99.75 % or more |
| 50 µm² | 50 % or more | 95.0 % or more | 99.50 % or more |
| 75 µm² | 25 % or more | 92.5 % or more | 99.25 % or more |
| 100 µm² | 0 % or more | 90 % or more | 99.00 % or more |

The relations provided in the above table may particularly be true for bunches of chips fabricated form the same epiwafer that preferably has a lateral extension in at least one spatial direction, e.g., a diameter, of 100 mm to 450 mm. For example, based on the above assumption, in case chips with sizes of 25 µm² are fabricated from an epiwafer, statistically 75 % or more of the total number of chips fabricated from this individual epiwafer are nano pipe free.

Considering an average nano pipe density 0.001 µm⁻² or less, one nano pipe or less may be present in case the chip size is 1000 µm². The above depicted table may be adopted based on this assumption of an average nano pipe density 0.001 µm⁻² or less such that the table would range from a chip size of 1 µm² resulting in a statistical number of nano pipe free chips of 99.9 % or more to a chip size of 10 µm² resulting in a statistical number of nano pipe free chips of 99 % or more and to a chip size of 1000 µm² resulting in a statistical number of nano pipe free chips of 0 % or more.

Correspondingly, considering an average nano pipe density 0.0001 µm⁻² or less, one nano pipe or less may be present in case the total area is 10000 µm². The above depicted table may be adopted based on this assumption of an average nano pipe density 0.0001 µm⁻² or less such that the table would range from a chip size of 1 µm² resulting in a statistical number of nano pipe free chips of 99.99 % or more to a chip size of 10 µm² resulting in a statistical number of nano pipe free chips of 99.9 % or more and to a chip size of 10000 µm² resulting in a statistical number of nano pipe free chips of 0 % or more.

In particular, the method allows fabricating micro LEDs which have no nano pipes at all, for use in various applications, e.g., display, illumination, communication or lighting devices.

Given an achieved non-zero nano pipe density of 0.1 µm⁻² or less on wafer-level, a distribution of this amount of nano pipes provides a high probability for upper end surface areas of active layer structures with side lengths typically used in micro LEDs which are completely free of nano pipes. However, the invention equally allows achieving this nano pipe density at the upper end face of the active layer structure in "macroscopic" LEDs, and most generally provides a nano pipe density of 0.1 µm⁻² or less on wafer-level. Due to their larger surface area, the presence of some nano pipes in an active-layer structure of a larger LED may be tolerable and less detrimental for their internal quantum efficiency of light emission. Even if the achieved effect on performance characteristics is thus more pronounced for micro LEDs, the invention is also useful in the fabrication of larger, "macroscopic" LEDs if they are desired without nano pipes.

The nano pipe density value can be determined for instance by surface inspection of the upper end surface of the active layer structure of an epiwafer, e.g., an GaN-on-Si epiwafer, using any suitable microscopic technique, for instance optical microscopy or electron microscopy. The inspection may be performed using a plan view of the upper end surface of the active layer structure or one or more cross-sectional views. It is also possible to determine a nano pipe density within the semiconductor structure, e.g., using a focused ion beam (FIB) for ablating material of the layers of the semiconductor structure. The exposed surface within the semiconductor structure can be inspected using any suitable microscopic technique.

In the method it is preferred that the substantially strain-relaxed or unstrained GaN layer is fabricated to have a threading dislocation density of 1 × 10⁹ cm⁻² or less. Preferably, the substantially strain-relaxed or unstrained GaN layer is fabricated to have a threading dislocation density of 1 × 10⁷ cm⁻² to 1 × 10⁹ cm⁻².

Accordingly, the method may provide an optimization interval for the threading dislocation density in the unstrained or strain-relaxed layer for a growth process on a hetero-substrate. Namely, it identifies the value range of the threading dislocation density between the lower boundary of 1 × 10⁷ cm⁻² and the upper boundary of 1 × 10⁹ cm⁻². In this context, the inventors have recognized that achieving an even lower dislocation density in the unstrained layer than the lower boundary is beneficial for achieving a nano pipe density at or below the mentioned upper nano pipe density threshold of 0.1 µm⁻². The inventors have recognized that dislocation densities lower than 1 × 10⁷ cm⁻² in growth processes on a hetero-substrate are typically associated with the growth of a high-quality, but strained GaN layer rather than an unstrained or strain-relaxed GaN layer. This in turn may lead to unwanted strain relaxation in the active layer structure which is associated with a higher dislocation density in the active layer structure that may not allow achieving the nano pipe density threshold. A dislocation density below 1 × 10⁷ cm⁻² would also be detrimental in that the methods required to achieve such values create higher processing cost without achieving a significant benefit in the performance characteristics. Such high processing cost may for instance arise from having to use more reactor time in growth of the GaN layer for achieving a threading dislocation density of less than 1 × 10⁷ cm⁻² in the strain-relaxed or unstrained layer than for achieving a threading dislocation density falling into the mentioned range.

It is noted that threading dislocation density values below 1 × 10⁷ cm⁻² in the strain-relaxed or unstrained GaN layer typically arise in fabrication processes and III-nitride structures involving homo-epitaxial growth on a GaN substrate ("GaN-on-GaN"), which are not claimed here and have the disadvantages explained hereinabove.

The method thus enables the fabrication of a semiconductor structure with a flat or substantially flat surface that is free or substantially free of nano pipes and that is suitable for fabrication of III-nitride electronic and optoelectronic devices, in particular micro LED devices with high crystal quality and superior functionality, e.g., due to reduced leakage currents.

Moreover, due to the presence of the substantially strain-relaxed or unstrained GaN layer, for fabricating the semiconductor structure, no additional layers for blocking nano pipes from propagating into an active layer structure are required for achieving a low nano pipe density in association with high performance characteristics. It is thus the presence of the substantially strain-relaxed or unstrained GaN layer, preferably, with the above-defined threading dislocation density that enables the realisation of the low nano pipe density at a distance that is between 200 nm above the substrate along the stacking direction and the upper end face of the active layer structure. As will be explained in more detail further below, optionally, a strain-engineering sub-stack can be arranged between the substantially strain-relaxed or unstrained GaN layer and the active layer structure to further reduce the nano pipe density in the active layer structure.

Achieving a nano pipe density of 0.1 µm⁻² or less a at a distance that is between 200 nm above the substrate along the stacking direction and the upper end face of the active layer structure is thus achieved by use of the substantially strain-relaxed or unstrained GaN layer, preferably, with a threading dislocation density of 1 × 10⁷ cm⁻² to 1 × 10⁹ cm⁻². It is particularly preferred that the substantially strain-relaxed or unstrained GaN layer has a threading dislocation density of 1 × 10⁷ cm⁻² to 5 × 10⁸ cm⁻² or less to provide a particularly low nano pipe density or even no nano pipes at all at a distance that is between 200 nm above the substrate along the stacking direction and the upper end face of the active layer structure.

Herein, "substantially strain-relaxed or unstrained" refers to the GaN layer having no compressive strain and no tensile strain, or at least compressive or tensile strain in the GaN layer that is below 0.1 % with respect to the lattice constants of bulk GaN, the latter being a= 3.189 Å and c= 5.178 Å at 300 K. Because the GaN layer is fabricated to be substantially strain-relaxed or unstrained, a strain decoupling between the substrate and the active layer structure can be achieved. This makes the method particular versatile with regard to the choice of the hetero-substrate.

The strain-relaxed or unstrained GaN layer may include, e.g., 5 % or less of one or more other III-material such as In and/or Al. Preferably, the strain-relaxed or unstrained GaN layer includes at least 95 % of Ga as the group-III material. Preferably, in the semiconductor structure, the substantially strain-relaxed GaN layer has an in-plane and/or an out-of-plane lattice parameter that differs no more than 5 % from the respective in-plane and/or an out-of-plane bulk lattice parameters of GaN. For example, lattice parameter may differ no more than 3 %, 2%, 1%, or 0% from the respective in-plane and/or an out-of-plane bulk lattice parameters.

Herein, a "nano pipe" is generally understood to be associated with a mixed or screw dislocation. A nano pipe generally is formed by a hollow tube with nanometre scale diameters. When assuming growth along the c-direction, a nano pipe often has {1-100} faceted sides. Such nano pipes with {1-100} faceted sides run substantially along the stacking direction, i.e., substantially vertically. Yet, it is also possible that when assuming a growth along the c-direction, nano pipes are present that are inclined relative to the stacking direction. These inclined nano pipes generally have faceted sides that are different from {1-100} faceted sides. Furthermore, in case the growth direction is along the m-direction or the a-direction of the semiconductor structure, the faceted sides of the nano pipes would change accordingly. That is, when assuming a growth along the m-direction or the a-direction, nano pipes generally have faceted sides that are different from {1-100} faceted sides, in particular, when running along the stacking direction, i.e., vertically. A nano pipe may be associated with open core screw-type or mixed type dislocations with larger Burgers vectors, |b|=±n*c (with n>1) and c being the out-of-plane lattice constant. Accidental growth mechanisms, growth mode or doping (Si, O, Mg) may influence the creation of a nano pipe. Impurity segregation such as oxygen may influence nano pipe growth. For example, nano pipes may have a diameter below 100 nm and equal or above 0.6 nm. A typical nano pipe may have a length of at least 25 nm, e.g., of at least 50 nm, such as of at least 100 nm. It is possible that a nano pipe has a length of 500 nm or more such as of 1 µm or more. In particular, a nano pipe may cause a leakage path that may affect performance of a III-nitride electronic or optoelectronic device.

Where the hetero-substrate, on which the substantially strain-relaxed or unstrained GaN layer, is fabricated is made of Si, it either consists of Si, or comprises substantially only Si, or has a Si-containing upper surface.

Preferably, in the method, fabricating the substantially strain-relaxed or unstrained GaN layer comprises
- in-situ monitoring and maintaining a constant curvature of the semiconductor structure. Preferably, in this regard, "constant" means within a range of +/- 10 km⁻¹. The curvature can be determined using an in-situ curvature measurement, which is per se known in the art.

Preferably, the method further comprises
- epitaxially fabricating, directly on the substantially strain-relaxed or unstrained GaN layer, a strain-engineering sub-stack. In case the substrate is made of or comprises Si, the strain-engineering sub-stack may have a compressive strain under fabrication. In case the substrate is made of or comprises sapphire (Al₂O₃), the strain-engineering sub-stack may have a tensile strain under fabrication. Fabricating the strain-engineering sub-stack preferably includes fabricating at least one GaN layer and at least one AlₓGa₁₋ₓN intermediate layer, x ≥ 0.5, the GaN layer having a thickness of 0.5 µm to 4.0 µm and the AlₓGa₁₋ₓN intermediate layer having a thickness of 5 nm to 25 nm. The GaN layer is grown at normal GaN growth temperatures such as between 1000 °C and 1050 °C, i.e., not at particularly high temperature.

The strain-engineering sub-stack's AlₓGa₁₋ₓN intermediate layer allows a reproducible strain-engineering in the strain-engineering sub-stack during fabrication of the semiconductor structure. The AlₓGa₁₋ₓN intermediate layer may be a low-temperature layer, i.e., grown at a lower temperature than usually used for epitaxial AlₓGa₁₋ₓN growth.

Preferably, in the method, the AlₓGa₁₋ₓN intermediate layer is fabricated using a growth temperature of 700 °C to 900 °C. This comparatively low growth temperature of the AlₓGa_{1- x}N intermediate layer stands in contrast to growth temperatures that are commonly used for growing AlₓGa₁₋ₓN, i.e., temperatures of 1050 °C to 1100 °C. Yet, the inventor has recognized that using comparatively low growth temperatures, i.e., of 700 °C to 900 °C for growing the AlₓGa₁₋ₓN intermediate layer has the advantage that compressive strain can be induced with the AlₓGa₁₋ₓN intermediate layer to the GaN-layer in a controlled and efficient manner.

For example, it is possible to fabricate the strain-engineering sub-stack with a compressive strain, using a setting of the GaN layer thickness and/or the AlₓGa₁₋ₓN intermediate layer thickness and/or its Al content. The strain-engineering sub-stack may comprise only a single GaN layer and a single AlₓGa₁₋ₓN intermediate layer and may start either with GaN layer or with the AlₓGa₁₋ₓN intermediate layer. However, it may be beneficial if the strain-engineering sub-stack comprises at least two repetitions of a sequence of the GaN layer and the AlₓGa₁₋ₓN intermediate layer or of the AlₓGa₁₋ₓN intermediate layer and the GaN layer, with x ≥ 0.5. By increasing the numbers of repetitions, the strain in the strain-engineering sub-stack can be more accurately and individually controlled. For example, each of the AlₓGa₁₋ₓN intermediate layers present in the strain-engineering sub-stack may have a different thickness and/or Al content to ensure an efficient strain balancing in the GaN-layers of the strain-engineering sub-stack. This allows further improving the crystal quality of the GaN-layers of the strain-engineering sub-stack. In addition, it can be expected that the crystal quality further improves with each repetition. This allows continuing the growth until a GaN-layer of the strain-engineering sub-stack has sufficient crystal quality for a certain application. It is also possible to grow additional repetitions until the crystal quality of the GaN-layer of the respective repetitions does not change anymore. The active layer structure may then be fabricated directly onto the strain-engineering sub-stack.

Fabricating a strain-engineering sub-stack as part of the semiconductor structure enables the application of sufficient compressive strain with the AlₓGa₁₋ₓN intermediate layer to the GaN-layer of the strain-engineering sub-stack to compensate the tensile strain created by the thermal expansion mismatch during cooling down from growth temperature to room temperature. This is particularly possible with an AlₓGa₁₋ₓN intermediate layer, with x ≥ 0.5, having a thickness of 5 nm to 25 nm. For example, Al content and thickness of the AlₓGa_{1- x}N intermediate layer may be chosen taking into account the thermal expansion mismatch between GaN and Si. To this end, it is particularly beneficial to consider the respective total thicknesses of the GaN layers and the substrate. For example, the GaN layers of the strain-engineering sub-stack may be grown with a thickness allowing strain-balancing to compensate thermal expansion during growth to achieve high crystal quality GaN layers in the strain-engineering sub-stack. Suitable thicknesses may lie in the range of 500 nm to several micrometers, e.g., 2 µm or 3 µm.

The substantially strain-relaxed or unstrained GaN layer may be realised by growth on one of a variety of different layer or layer structures that can be arranged on the hetero-substrate. The choice of layer or layer structures on which the substantially strain-relaxed or unstrained GaN layer is fabricated typically depends on the choice of hetero-substrate used for the fabrication process. As stated above, the hetero-substrate may be made of, e.g., sapphire, SiC or Si. Taking the example of sapphire or SiC, it may be beneficial that the layer or layer structure, on which the substantially strain-relaxed or unstrained GaN layer is grown, is an epitaxial lateral-overgrowth (ELO) mask layer. This generally includes that the ELO mask layer is pre-structured, e.g., using lithographic techniques, for forming structures that support an epitaxial lateral-overgrowth mode in a subsequent epitaxial growth process. For fabricating such a pre-structured ELO mask layer, ex-situ fabrication processes are typically required.

According to a particularly advantageous embodiment that involves the use of a hetero-substrate made of Si, such an ex-situ fabricated ELO mask layer is not required. In particular, it includes in-situ fabricating a self-organized template layer on which the substantially strain-relaxed or unstrained GaN layer is grown epitaxially (i.e., also in-situ). The self-organized template layer is explained in the following in more detail. Accordingly, additionally or alternatively, the method may comprise
- epitaxially growing on the Si substrate a self-organized template layer having a template pit density of 1×10⁷ cm⁻² to 1×10¹¹ cm⁻²; and
- fabricating the substantially strain-relaxed or unstrained GaN layer directly on the self-organized template layer.

The self-organized template layer forms a self-organized template for the growth of further layers to be grown on top of the self-organized template layer. During fabrication of the self-organized template layer, template pits form in a self-organized manner, since the positions at which they form is not predefined, e.g., by a mask. Instead, during fabrication of the self-organized template layer, the template pits form at random positions that are favoured by the growth conditions. In other words, the template pits of the self-organized template layer form in a microscopically unpredictable, self-organized manner without requiring any structural processing steps applied to the self-organized template layer. Despite the self-organized template layer having a high template pit density and thus poor crystal quality, the self-organized template layer preferably is a crystalline layer with a predominant crystal structure, e.g., Wurtzite, preferably, Wurtzite AIN.

It is the comparatively high pit density in the self-organized template layer that contributes to an efficient relief of strain in the substantially strain-relaxed or unstrained GaN layer resulting from a lattice mismatch between the material of the self-organized template layer and the material of the substrate. In turn, the efficient relief of strain in the substantially strain-relaxed or unstrained GaN layer contributes to preventing strain to propagate into the active layer structure or, if present, the strain-engineering sub-stack, and to providing a substantially strain-free surface, e.g., for the further growth of the active layer structure or the strain-engineering sub-stack. The self-organized template layer thus allows the fabrication of the substantially strain-relaxed or unstrained GaN layer directly on the self-organized template layer such that further layers can be grown with comparatively high crystal quality on top of the strain-relaxed or unstrained GaN layer.

When growing the substantially strain-relaxed or unstrained GaN layer onto the self-organized template layer, the material of the substantially strain-relaxed or unstrained GaN layer may not fill the pits of the template layer but only cover them. Alternatively, when growing the substantially strain-relaxed or unstrained GaN layer onto the self-organized template layer, the material of the substantially strain-relaxed or unstrained GaN layer may at least partly fill the pits of the template layer and also cover them. After having grown the substantially strain-relaxed or unstrained GaN layer onto the self-organized template layer, the template pits may be thus either be at least partly filled with material of the substantially strain-relaxed or unstrained GaN layer or they may be not filled with material of the substantially strain-relaxed or unstrained GaN layer.

The template pits may extend from the interface between the self-organized template layer and the substantially strain-relaxed or unstrained GaN layer into the self-organized template layer. An individual template pit forms a recess in the surface of the self-organized template layer. The template pits may have a depth of at least 7 nm and can extend up to 50 nm or even further into the self-organized template layer. A fraction of template pits of the self-organized template layer may be allowed to fully penetrate the self-organized template layer along its thickness, i.e., from the interface between the self-organized template layer and the substantially strain-relaxed or unstrained GaN layer down to the interface between the self-organized template layer and the substrate. However, this may occur as a consequence of growth parameter settings in a given individual reactor. The method described herein may comprise fabricating a self-organized template layer that has only pits which do not fully penetrate the self-organized template layer down to the substrate. The term "template pit density" refers to the density of template pits distributed over a surface or (in particular when assessing the density from a cross sectional image after growth) interface, e.g., of the self-organized template layer. It is defined by the number of template pits present within a predefined surface unit area.

Preferably, the method comprises
- providing the substrate having a lateral extension in at least one spatial direction, e.g., a diameter, of 100 mm or more, or 150 mm, or more than 150 mm, preferably, of 150 mm to 450 mm, the substrate having a silicon surface.

It is possible that in the method, the upper end surface is fabricated such that at least one nano pipe, if present, is connected to a V-pit being configured as a pit that in a cross-sectional view of the active layer structure has a V-shape.

Optionally, the method may comprise fabricating the active layer structure in a way that
- epitaxial growth parameters are used to maintain a density of the screw-type or mixed type dislocations having an open core and {1-100} faceted sides, i.e., the nano pipes, at a value that is smaller than or equal to that of the V-pits.

V-pit formation may be caused by local strain relaxation in the active layer structure and/or by In segregation. Within the framework of this specification, a V-pit at the upper end of the active layer structure is arranged at the upper end face of the active layer structure, i.e., that surface or interface of the active layer structure, which is created last during growth. A V-pit present at the upper end face may have a hexagonal shape in top view. The hexagonal shape may be regular or irregular. A V-pit present at the upper end face may have {10-11} facet planes. The {10-11} facet planes are energetically stable during growth of the semiconductor structure along the c-direction. In case, the growth direction is not the c-direction, but, e.g., the m-direction, the energetically stable facet planes change accordingly. V-pits at the upper end face may be covered by a subsequent layer following the active layer structure along the stacking direction. For example, a subsequent layer following the active layer structure along the stacking direction may be covering or even partly or fully filling the V-pits at the upper end face.

Nano pipes in connection with V-pits are also discussed in the research article by Nikhil Sharma, Paul Thomas, David Tricker, and Colin Humphreys titled "Chemical mapping and formation of V-defects in InGaN multiple quantum wells." Published in Appl. Phys. Lett. 28 August 2000; 77 (9): 1274-1276. https://doi.org/10.1063/1.1289904. In this article, it is described that threading dislocations can open up to give nanotubes (corresponding to the nano pipes described herein) or open-core defects. Moreover, Nikhil Sharma et al. suggest that this also seems to be the mechanism of V-pit formation, under growth conditions where the {10-11} planes are stabilized.

Optionally, the method comprises
- thinning the semiconductor structure starting from a backside of the semiconductor structure up to the active layer structure such that the active layer structure remains.

After thinning, III-nitride based electronic and optoelectronic device may be fabricated from the semiconductor structure, e.g., by adding contacts etc.

Accordingly, the method may further comprise
- fabricating an electronic device or an optoelectronic device from the remaining active layer structure, the optoelectronic device being configured to emit light under electrical or optical excitation. The optoelectronic device may thus be an LED, in particular, a micro LED. The electronic device may comprise a transistor structure such as a HEMT structure or the like.

The present invention also relates to a semiconductor structure. The semiconductor structure may be fabricated using the afore-described method. The semiconductor structure comprises along a stacking direction:
- a hetero-substrate, hereinafter called, substrate,
- a substantially strain-relaxed or unstrained GaN layer arranged above the substrate, and
- an epitaxial active layer structure arranged above the GaN layer along the stacking direction and extending along the stacking direction from a lower end face facing towards the GaN layer to an upper end face opposite the lower end face. At a distance that is between 200 nm above the substrate along the stacking direction and the upper end face of the active layer structure, the semiconductor structure has a nano pipe density of 0.1 µm⁻² or less, wherein a nano pipe density denotes a density of screw-type or mixed type dislocations having an open core, i.e., the nano pipes.

It is particularly preferred that the semiconductor structure has a nano pipe density of 0.1 µm⁻² or less at a distance, preferably, at each (or every) distance, that is between the upper end face of the active layer structure and at least 1 µm below the upper end face, e.g., between the upper end face and at least 2 µm below the upper end face such as between the upper end face and at least 3 µm below the upper end face. In particular, the semiconductor structure may have a nano pipe density of 0.1 µm⁻² or less at the upper end face. Having a volume with a thickness of 1 µm or more, 2 µm or more or even 3 µm or more within the active layer structure with a nano pipe density of 0.1 µm⁻² or less may particularly improve a performance of the semiconductor structure or an electronic or optoelectronic device fabricated therefrom. Such an improved performance may be based on a prevention or at least reduction of leakage currents caused by the low nano pipe density. In the semiconductor structure, it is particularly preferred that the active layer structure has a nano pipe density of 0.1 µm⁻² or less within its complete volume, i.e. the active layer structure is essentially free of nano pipes.

Preferably, in the semiconductor structure, a distance, preferably, at each (or every) distance, that is between 200 nm above the substrate along the stacking direction and the lower end face of the active layer structure, the semiconductor structure has a nano pipe density of 0.1 µm⁻² or less. A semiconductor structure with a low nano pipe density of 0.1 µm⁻² or less within a volume extending between 200 nm above the substrate and the lower end face of the active layer structure may contribute to a comparatively high crystal quality in the active layer structure and thereby to a reduction of leakage currents during operation. The volume extending between 200 nm above the substrate and the lower end face of the active layer structure may particularly include the substantially strain-relaxed or unstrained GaN layer and optionally one or more of a strain-engineering sub-stack and a self-organized template layer or at least parts of it.

Preferably, in the semiconductor structure, at each distance that is between 200 nm above the substrate along the stacking direction and the upper end face of the active layer structure, the semiconductor structure has a nano pipe density of 0.1 µm⁻² or less. In other words, it is possible that at every distance that is between 200 nm above the substrate along the stacking direction and the upper end face of the active layer structure, the semiconductor structure has a nano pipe density of 0.1 µm⁻² or less. Accordingly, it is preferred that the semiconductor structure has a low nano pipe density of 0.1 µm⁻² or less within a volume extending between 200 nm above the substrate and the upper end face of the active layer structure. Such a semiconductor structure thus may be even more robust against leakage currents.

Preferably, the substantially strain-relaxed or unstrained GaN layer has a threading dislocation density of 1 × 10⁹ cm⁻² or less. For example, the substantially strain-relaxed or unstrained GaN layer may have a threading dislocation density of 1 × 10⁷ cm⁻² to 1 × 10⁹ cm⁻ 2

Preferably, the active layer structure comprises at least two layers forming an interface therebetween, wherein the active layer structure has a nano pipe density of 0.1 µm⁻² or less at the interface. An active layer structure having a nano pipe density of 0.1 µm⁻² or less at an interface shared between two layers of the active layer structure may enable fabrication of an electronic or optoelectronic device with high performance characteristics. In particular, the interface having a nano pipe density of 0.1 µm⁻² or less may be an interface between a quantum well and an n-doped layer or a p-doped layer of an LED. Accordingly, when having the quantum well interface with a nano pipe density of 0.1 µm⁻² or less, a lower failure rate for electronic or optoelectronic devices, in particular micro LEDs can be achieved. Furthermore, leakage currents may be avoided or at least significantly reduced.

Preferably, in the semiconductor structure, the at least one nano pipe, if present, extends in the active layer structure within an angle range of +/- 45° with respect to the stacking direction. For example the at least one nano pipe, if present, may extend in the active layer structure within an angle range of +/- 25° with respect to the stacking direction or +/- 10° with respect to the stacking direction. It may be possible that the at least one nano pipe, if present, extends in the active layer structure within an angle range of +/- 5° with respect to the stacking direction. Preferably, in the semiconductor structure, at least 80 %, e.g., at least 90 % or at least 95 % of the nano pipes, if present, extend substantially along the stacking direction.

Preferably, in the semiconductor structure, at least 80 %, e.g., at least 90 % or at least 95 % of the nano pipes, if present, have {1-100} faceted sides. Nano pipes with {1-100} faceted sides may particularly be present in case the stacking direction, i.e., the growth direction, points along the c-direction of the semiconductor structure. In case the growth direction is along the c-direction of the semiconductor structure, nano pipes with {1-100} faceted sides run vertically in the semiconductor structure, i.e., along the stacking direction.

Preferably, at least 80 %, e.g., at least 90 % or at least 95 % of the nano pipes, if present, run substantially vertically in the semiconductor structure, i.e., along the stacking direction. In case the growth direction is not the c-direction, but, e.g., the m-direction or the a-direction, these vertically running nano pipes have faceted sides that are different from {1-100} faceted sides. That is, in case the growth direction is not the c-direction, but, e.g., the m-direction or the a-direction, the faceted sides of the nano pipes change accordingly with respect to {1-100} faceted sides of nano pipes present at 80 % or more in a semiconductor structure fabricated along the c-direction.

Preferably, in the semiconductor structure, at least 80 %, e.g., at least 90 % or at least 95 % of the nano pipes, if present, have a diameter of 0.6 nm to 100 nm, e.g., at the upper end face. For example, nano pipes may have a diameter of 1 nm to 60 nm, e.g., at the upper end face or a diameter of 1 nm to 30 nm, e.g., at the upper end face. The presence of such nano pipes having a diameter of 0.6 nm to 100 nm can be investigated using, e.g., atomic force microscopy (AFM). In the semiconductor structure, it is possible that the at least one nano pipe, if present, is connected to a V-pit that is configured as a pit that in a cross-sectional view of the epitaxial active layer structure have a V-shape.

Preferably, in the semiconductor structure, the active layer structure includes at least one quantum well or one or more multi-quantum-well structures of III-nitride materials. A multi-quantum-well structure preferably comprises at least two quantum wells. For example, an active layer structure may comprise a n-doped layer followed by a single quantum well or a multi-quantum-well followed by a p-doped layer along the stacking direction. Such an active layer structure may be used for light emission. For example, a quantum well may comprise of InGaN or one or more multi-quantum-well structures may comprise several layers of InGaN, e.g., for the fabrication of an LED. Additionally or alternatively, a quantum well or one or more multi-quantum-well structures may comprise layers of AlGaN, e.g., for the fabrication of a photodetector, e.g., for UV light. Accordingly, it is preferred that a quantum well or one or more multi-quantum-well structures comprises at least one InGaN or AlGaN quantum well. Preferably, the quantum well is or the one or more multi-quantum-well structures are embedded between a p-doped and an n-doped layer to create a p-n junction. The quantum well or the one or more multi-quantum-well structures and the p-doped and an n-doped layers together may form the active layer structure.

Optionally, the semiconductor structure comprises a strain-bridging layer arranged between the substantially strain-relaxed or unstrained GaN layer and the active layer structure, the strain-bridging layer being made of a III-nitride material with a lower percentage of the group-III material than in the quantum well of the active layer structure. Accordingly, there may be further layers between the substantially strain-relaxed or unstrained GaN layer and the active layer structure. For example, there can be an InGaN layer with intermediate In content as the strain-bridging layer that may optionally be potentially n-type doped and that bridges the strain to an InGaN quantum well of the active layer structure. Alternatively, the strain-bridging layer may be an AlGaN layer, e.g., when an AlGaN quantum well is used in the active layer structure. However, the active layer structure can also be arranged directly on the substantially strain-relaxed or unstrained GaN layer. In case, a strain-engineering sub-stack is present in the semiconductor structure, the strain-bridging layer may also be arranged between the strain-engineering sub-stack and the active layer structure. Furthermore, in case, a strain-engineering sub-stack is present in the semiconductor structure, the strain-bridging layer may also be arranged between the substantially strain-relaxed or unstrained GaN layer and the strain-engineering sub-stack.

Preferably, the upper end face of the active layer structure belongs to a p-doped layer covering a quantum well or a multi-quantum-well structure of III-nitride materials that follows a n-doped layer.

Optionally, the active layer structure may include a transistor structure, e.g., a HEMT structure, a junction-gate field-effect transistor (jFET), a fin field-effect transistor (finFET), or a metal insulator semiconductor field-effect transistor (MISFET), for example, with recessed gate. The HEMT structure may be a lateral HEMT structure or a vertical HEMT structure. Additionally or alternatively to a transistor structure, the active layer structure may include an LED such as a resonant cavity LED or a diode structure, e.g., a laser diode structure or a Schottky diode or other optoelectronic or electronic device structures. In electronics having no or only a smaller number of nano pipes can be beneficial to avoid leakage. The LED may be formed by an n-doped layer followed by a quantum well or one or more multi-quantum-well structures that is followed by a p-doped layer. For example, for multi-colour emission, an LED may comprise several multi-quantum-well structures that each are configured to emit light at a different colour, e.g., red, green and blue for achieving white colour light emission by mixing the wavelengths of the light emitted by the multi-quantum-well structures. For example, the several multi-quantum-well structures for multi-colour light emission may have different quantum well thicknesses to enable light emission at different colours.

It is possible that the active layer structure includes a transistor structure such as a HEMT in addition to an LED, i.e. in addition to a quantum well configured for emitting light, i.e. combinations of different functions in the active layer structure are possible.

Additionally or alternatively, the active layer structure may include a fin structure. Preferably, the fin structure is configured to be used in radio-frequency applications and may comprise a GaN fin.

Preferably, the semiconductor structure comprises a hetero-substrate. Preferably, the hetero-substrate of the semiconductor structure has a Si-containing substrate surface facing along the stacking direction.

Preferably, the substantially strain-relaxed or unstrained GaN layer is part of a strain-decoupling sub-stack, the strain-decoupling sub-stack comprising
- a self-organized template layer arranged directly on the substrate, the self-organized template layer comprising template pits of arbitrary shape with a template pit density of 1×10⁷ cm⁻² to 1×10¹¹ cm⁻², and
- the substantially strain-relaxed or unstrained GaN layer arranged directly on the self-organized template layer, the substantially strain-relaxed or unstrained GaN layer, preferably, having a substantially smooth surface pointing along the stacking direction.

Preferably, the self-organized template layer has a threading dislocation density of 10⁹ cm^{- 2} or more throughout a thickness of the self-organized template layer. Preferably, the smooth surface of the substantially strain-relaxed or unstrained GaN layer has a reflectivity of 35 % or more. Preferably, the substantially strain-relaxed or unstrained GaN layer comprises dislocations that bend under an angle of 15° to 45° with respect to an interface formed between the self-organized template layer and the substantially strain-relaxed or unstrained GaN layer. Preferably, the template pits of the self-organized template layer have a template pit size of 1 nm to 100 nm. Preferably, the template pits of the self-organized template layer have an average template pit distance between adjacent template pits that is in the range of 200 nm to 2000 nm.

Preferably, the semiconductor structure comprises a strain-engineering sub-stack arranged directly on the substantially strain-relaxed or unstrained GaN layer and comprising at least one GaN layer and at least one AlₓGa₁₋ₓN intermediate layer, with x ≥ 0.5, the GaN layer having a thickness of 0.5 µm to 4.0 µm, the AlₓGa₁₋ₓN intermediate layer having a thickness of 5 nm to 25 nm. Preferably, the strain-engineering sub-stack comprises at least two repetitions of a sequence of the GaN layer and the AlₓGa₁₋ₓN intermediate layer, or of the AlₓGa₁₋ₓN intermediate layer and the GaN layer, with x ≥ 0.5.

Furthermore, the present invention relates to an electronic device comprising an active layer structure that has a nano pipe density of 0.1 µm⁻² or less, wherein a nano pipe density denotes a density of screw-type or mixed type dislocations having an open core, hereinafter called nano pipes, the active layer structure comprising at least one transistor structure. For example, the at least one transistor structure may be or may comprise one of a HEMT structure, a jFET, a finFET, a MISFET or the like or combinations thereof.

The present invention also relates to an optoelectronic device comprising the semiconductor structure described herein, wherein the active layer structure is configured to emit light under electrical or optical excitation. Preferably, the optoelectronic device is or comprises a laser, e.g. a laser diode, or a LED, e.g., a micro LED, for example, a resonant cavity LED.

The present invention also relates to an optoelectronic device comprising an active layer structure that has a nano pipe density of 0.1 µm⁻² or less, wherein a nano pipe density denotes a density of screw-type or mixed type dislocations having an open core, the optoelectronic device being configured as a micro LED, wherein the active layer structure comprising the quantum well, e.g., a III-nitride quantum well, is configured to emit electromagnetic radiation in a wavelength range of 400 nm to 800 nm. For example, an optoelectronic device may comprise the semiconductor structure described herein, and being configured as a micro LED, wherein at least one quantum well of the micro LED, e.g., a III-nitride quantum well, is configured to emit electromagnetic radiation in a wavelength range of 400 nm to 800 nm. Alternatively, the optoelectronic device may comprise an active layer structure that has a nano pipe density of 0.1 µm⁻² or less, wherein a nano pipe density denotes a density of screw-type or mixed type dislocations having an open core, the optoelectronic device being configured as a micro LED, wherein the active layer structure comprising the quantum well, e.g., a III-nitride quantum well, is configured to emit electromagnetic radiation in a wavelength range of 200 nm to 400 nm. For example, an optoelectronic device may comprise the semiconductor structure described herein, and being configured as a micro LED, wherein at least quantum well, e.g., a III-nitride quantum well, is configured to emit electromagnetic radiation in a wavelength range of 200 nm to 400 nm. In some embodiments, the micro LED is not tuneable. However, other embodiments have tuneable micro LEDs. In particular, for a micro LED, a comparatively low nano pipe density is of advantage because due to the small size of a micro LED, nano pipes may cause the micro LED to lose its functionality resulting in a non-operating device; e.g. in a micro LED based display resulting in a dead pixel.

It shall be understood that the aspects described above, and specifically the method of claim 1, and the semiconductor structure of claim 6, have similar and/or identical preferred embodiments, in particular as defined in the dependent claims.

It shall be further understood that a preferred embodiment of the present invention can also be any combination of the dependent claims or above embodiments with the respective independent claim.

These and other aspects of the invention will be apparent from and elucidated with reference to the embodiments described hereinafter with reference to the drawings.

### BRIEF DESCRIPTION OF THE DRAWINGS

- Fig. 1:: shows a flow diagram representing a method of fabricating a semiconductor structure;
- Fig. 2:: schematically and exemplary shows a semiconductor structure in a cross-sectional view, the semiconductor structure having an active layer structure with nano pipes;
- Fig. 3:: schematically and exemplary shows a semiconductor structure in a cross-sectional view, the semiconductor structure having an active layer structure with no nano pipes;
- Fig. 4:: schematically and exemplary shows a semiconductor structure in a cross-sectional view, the semiconductor structure having an additional strain-engineering sub-stack and a self-organized template layer;
- Fig. 5:: schematically and exemplary shows an active layer structure of a semiconductor structure in a cross-sectional view, the active layer structure having nano pipes one of which is connected to a V-pit;
- Fig. 6:: schematically and exemplary shows an active layer structure of a semiconductor structure in a top view, the active layer structure having V-pits with {10-11} facet planes and a nano pipe;
- Fig. 7:: shows a cross-sectional transmission electron microscopy micrograph showing along a stacking direction of a semiconductor structure an AlGaN interlayer of a strain-engineering sub-stack as well as an n-doped GaN layer, a multiquantum-well structure and a p-doped GaN layer of an active layer structure;
- Fig. 8:: shows a cross-sectional transmission electron microscopy micrograph of an excerpt of the semiconductor structure shown in Fig. 7 depicting parts of the active layer structure comprising the multi-quantum-well structure;
- Fig. 9:: schematically and exemplary shows a self-organized template layer in a cross-sectional view, the self-organized template comprising a plurality oftemplate pits; and
- Fig. 10:: schematically and exemplary shows an active layer structure comprising several nano pipes that are arranged at different positions within the active layer structure.

### DETAILED DESCRIPTION OF EMBODIMENTS

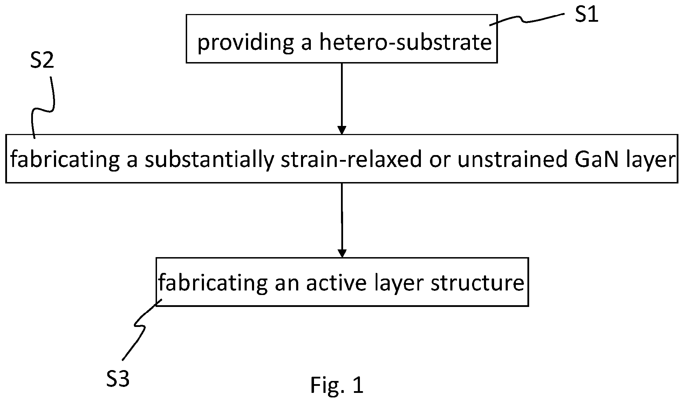

Figure 1 shows a flow diagram representing a method of fabricating a semiconductor structure such as a micro LED, an epiwafer, e.g., a GaN-on-Si epiwafer, or an LED array. In the method, a hetero-substrate is provided that is made of Si (step S1). However, also a hetero-substrate made of or comprising additional or other materials than Si can be used. For example, the hetero-substrate may be made of or may comprise sapphire or silicon carbide.

The hetero-substrate is provided on a substrate holder in a growth chamber of a growth setup for epitaxial growth of semiconductors. For example, the method can be carried out, e.g., using a molecular beam epitaxy (MBE) setup or a metalorganic vapour phase epitaxy (MOVPE) setup, sometimes also referred to as MOCVD, or other suitable crystal growth setups, e.g., chemical vapour deposition (CVD) setup, liquid phase epitaxy (LPE), and hydride vapour phase epitaxy (HVPE). The employed growth setup, often called reactor, preferably, allows changing one or more growth parameters for fabricating the semiconductor structure. For example, a growth parameter can be an applied pressure, a gas flow ratio and a growth temperature. Also, different growth modes may be applied during fabrication of the semiconductor structure, wherein different growth modes may be characterized by different sets of growth parameters or values or value ranges for specific growth parameters.

The hetero-substrate made of Si has a diameter of 300 mm. However, also other hetero-substrates having different diameters may be used. Yet, it is preferred that the hetero-substrate's diameter is at least 100 mm. For example, substrates with a lateral extension in at least one spatial direction, e.g., a diameter, of 100 mm to 450 mm may be used. In particular, round substrates with a diameter of 100 mm to 450 mm may be used or non-round substrates with a lateral extension in at least one spatial direction of the non-round shape of 100 mm to 450 mm may be used.

On the provided hetero-substrate, a substantially strain-relaxed or unstrained GaN layer having a threading dislocation density, of 1 × 10⁷ cm⁻² to 1 × 10⁹ cm⁻² is epitaxially fabricated (step S2). Thereby, the substantially strain-relaxed or unstrained GaN layer has compressive or tensile strain below 0.1 % with respect to the lattice constants of bulk GaN. It may even be achieved that the substantially strain-relaxed or unstrained GaN layer has no compressive strain and no tensile strain. Due to the GaN layer being substantially strain-relaxed or unstrained, i.e. substantially strain-free, a strain decoupling between the hetero-substrate and further layers grown on top of the substantially strain-relaxed or unstrained GaN layer can be achieved. This allows fabricating further layers grown on top of the substantially strain-relaxed or unstrained GaN layer with comparatively high crystal quality and a low nano pipe density. The substantially strain-relaxed or unstrained GaN layer allows fabricating further layers on top of the substantially strain-relaxed or unstrained GaN layer that are also substantially strain-relaxed or unstrained.

For example, as in the method, an active layer structure is fabricated onto the substantially strain-relaxed or unstrained GaN layer (step S3). Due to the strain decoupling, the semiconductor structure is fabricated with a nano pipe density of 0.1 µm⁻² or less, e.g. of 0.01 µm⁻² or less, such as 0.001 µm⁻² or less or 0.0001 µm⁻² or less at a distance that is between 200 nm above the substrate along the stacking direction and the upper end face of the active layer structure. The strain-decoupling thus enables fabricating the semiconductor structure substantially free of nano pipes. The active layer structure may comprise, e.g., a quantum well or a multi-quantum-well structure of III-nitride materials, e.g., GaN, InGaN and/or AlGaN and may be configured to emit light under application of an operating voltage or under optical excitation. Additionally or alternatively to a quantum well of III-nitride materials, the active layer structure may comprise a transistor structure such as a HEMT structure.

Optionally, before fabricating the substantially strain-relaxed or unstrained GaN layer on top of the substrate, a self-organized template layer can be fabricated directly on the substrate. In this case, the substantially strain-relaxed or unstrained GaN layer is fabricated onto the self-organized template layer. The self-organized template layer comprises template pits of arbitrary shape with a template pit density of 1×10⁷ cm⁻² to 1×10¹¹ cm⁻². "Template pit density" refers to the density of template pits distributed over a surface or (in particular when assessing the density from a cross sectional image after growth) interface, e.g., of the self-organized template layer. It is defined by the number of template pits present within a predefined surface unit area.

While the self-organized template layer, based on the comparatively high template pit density, may seem to have a comparatively poor crystal quality, with its rather high template pit density, it forms a self-organized template for the growth of further layers to be grown on top of the self-organized template layer. During fabrication of the self-organized template layer, the template pits form in a self-organized manner, since the positions at which they form is not predefined, e.g., by a mask. Instead, during fabrication of the self-organized template layer, the template pits form at random positions that are favoured by the growth conditions. In other words, the template pits of the self-organized template layer form in a self-organized manner without any structural processing of the self-organized template layer.

The comparatively high template pit density in the self-organized template layer may contribute to an even more efficient relief of strain in the substantially strain-relaxed or unstrained GaN layer resulting from a lattice mismatch between the material of the self-organized template layer and the material of the substrate.

Furthermore, before fabricating the active layer structure on top of the substantially strain-relaxed or unstrained GaN layer, optionally, a strain-engineering sub-stack can be fabricated directly on the substantially strain-relaxed or unstrained GaN layer. In this case, the active layer structure is fabricated onto the strain-engineering sub-stack.

The strain-engineering sub-stack is preferably fabricated to have at least one GaN layer and at least one AlₓGa₁₋ₓN intermediate layer, with x ≥ 0.5, the GaN layer having a thickness of 0.5 µm to 4.0 µm, the AlₓGa₁₋ₓN intermediate layer having a thickness of 5 nm to 25 nm. The strain-engineering sub-stack enables a precise strain-engineering with high uniformity in the strain-engineering sub-stack. In particular, with the AlₓGa₁₋ₓN intermediate layer, it may be possible to compensate tensile strain with a compressive strain component to the GaN, using a setting of the GaN layer thickness and/or the AlₓGa₁₋ₓN intermediate layer thickness and/or its Al content. Thereby, due to accurate and precisely controlled strain-engineering, thick layer stacks and high crystal quality GaN can be achieved.

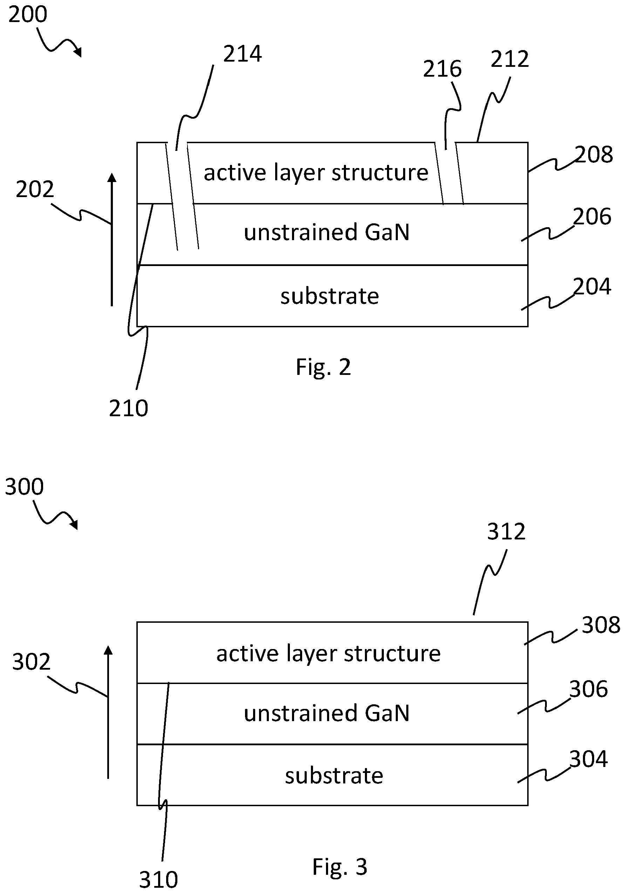

Figure 2 schematically and exemplary shows a semiconductor structure 200 in a cross-sectional view. The semiconductor structure 200 comprises along a stacking direction 202 a substrate 204, a substantially strain-relaxed or unstrained GaN layer 206 and an active layer structure 208. The semiconductor structure 200 may be fabricated by carrying out the method of fabricating a semiconductor structure as described with reference to figure 1.

The semiconductor structure's substrate 204 is a hetero-substrate and may be made of, e.g., silicon, sapphire or silicon carbide. The substrate 204 may have a thickness of at least 1 millimetre, preferably, of 1.2 mm to 1.6 mm. For example, the substrate 204 can be of circular shape having a diameter of 100 mm or more. Preferably, the substrate has a diameter of 300 mm or more, e.g., of 450 mm. Alternatively, a substrate with a non-round shape may be used having a lateral extension in at least one spatial direction of 100 mm to 450 mm. The substantially strain-relaxed or unstrained GaN layer 206 is arranged directly on top of and in direct contact with the substrate 204 and has a threading dislocation density, of 1 × 10⁷ cm⁻² to 1 × 10⁹ cm⁻².

The active layer structure 208 is arranged directly on top of and in direct contact with the substantially strain-relaxed or unstrained GaN layer 206. In particular, the active layer structure 208 extends along the stacking direction 202 from a lower end face 210 facing towards the substantially strain-relaxed or unstrained GaN layer 206 to an upper end face 212 opposite the lower end face 210. On the upper end face 212, the active layer structure 208 comprises nano pipes 214, 216 with a nano pipe density of 0.1 µm⁻² or less. The nano pipes 214, 216 are screw-type or mixed type dislocations having a hollow open core.

Figure 3 schematically and exemplary shows a semiconductor structure 300 in a cross-sectional view. The semiconductor structure 300 may be fabricated by carrying out the method of fabricating a semiconductor structure as described with reference to figure 1. The semiconductor structure 300 is configured similar to the semiconductor structure 200 described with reference to figure 2 and also comprises along a stacking direction 302 a substrate 304, a substantially strain-relaxed or unstrained GaN layer 306 and an active layer structure 308. Corresponding elements are denoted with corresponding reference numerals, wherein the first number "2" has been replaced by "3". For the configuration of these elements, it thus referred to the respective description of figure 2. Yet, there is an important difference between semiconductor structure 200 and semiconductor structure 300 that is, the semiconductor structure 300 has active layer structure 308 that is formed without any nano pipes, i.e., the semiconductor structure 300 is completely free of nano pipes.

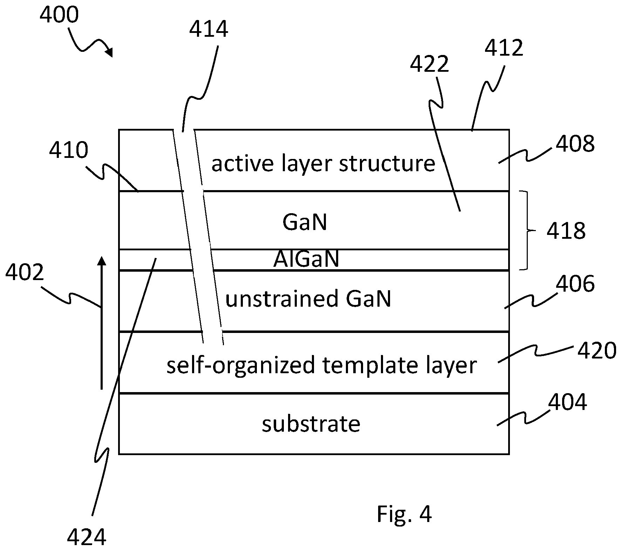

Figure 4 schematically and exemplary shows a semiconductor structure 400 in a cross-sectional view. The semiconductor structure 400 may be fabricated by carrying out the method of fabricating a semiconductor structure as described with reference to figure 1.

The semiconductor structure 400 is configured similar to the semiconductor structure 200 described with reference to figure 2 and the semiconductor structure 300 described with reference to figure 3. Corresponding elements of the semiconductor structure 400 are therefore denoted with reference numerals corresponding to the elements of the semiconductor structure 200 and semiconductor structure 300, wherein the first number "2" or "3" has been replaced by "4". For the configuration of these elements, it thus referred to the respective description of figures 2 and 3.

However, in contrast to semiconductor structure 200 and semiconductor structure 300, semiconductor structure 400 comprises an additional strain-engineering sub-stack 418 and a self-organized template layer 420.

The self-organized template layer 420 is arranged directly on the substrate 404 and comprises template pits. The template pits have a template pit density of 1×10⁷ cm⁻² to 1×10¹¹ cm⁻², preferably, of 1×10⁸ cm⁻² to 1×10¹⁰ cm⁻² or of 1×10⁸ cm⁻² to 3×10⁹ cm⁻², in particular, of 1×10⁹ cm⁻² to 3×10⁹ cm⁻².

The strain-engineering sub-stack 418 is arranged on the substantially strain-relaxed or unstrained GaN layer 406 and comprises at least one GaN layer 422 and at least one AlₓGa₁₋ₓN intermediate layer 424, with x ≥ 0.5. The GaN layer 422 has a thickness of 0.5 µm to 4.0 µm, preferably of 0.5 µm to 2.0 µm, the AlₓGa₁₋ₓN intermediate layer 424 has a thickness of 5 nm to 25 nm, preferably, of 10 nm to 15 nm. The strain-engineering sub-stack 418 may comprise only a single GaN layer 422 and a single AlₓGa₁₋ₓN intermediate layer 424 and may start either with GaN layer 422 or with the AlₓGa₁₋ₓN intermediate layer 424. However, it may be beneficial if the strain-engineering sub-stack 418 comprises at least two repetitions of a sequence of the GaN layer 422 and the AlₓGa₁₋ₓN intermediate layer 424 or of the AlₓGa₁₋ₓN intermediate layer 424 and the GaN layer 422. By increasing the number of repetitions, the strain in the strain-engineering sub-stack 418 can be more accurately and individually controlled.

When using the strain-engineering sub-stack 418 and the self-organized template layer 420 in addition to the substrate 404, the substantially strain-relaxed or unstrained GaN layer 406 and the active layer structure 408, it is possible to even better engineer the strain evolution in the semiconductor structure 400. In particular, a controlled strain evolution within the layer stack of the semiconductor structure 400 can be achieved and enables arranging a high crystal quality III-nitride layers of the active layer structure 408 on the strain-relaxed or unstrained GaN layer 406. In particular, the layer stack of the semiconductor structure 400 enables an efficient decoupling of strain that would otherwise arise from a lattice mismatch between the hetero-substrate 404 and the III-nitride layers applied above the substrate 404.

Furthermore, since the strain-engineering sub-stack 418 is arranged on a substantially strain-free basis, i.e., the substantially strain-relaxed or unstrained GaN layer 406, a particularly precise strain-engineering with high uniformity may be possible in the strain-engineering sub-stack 418. It is thus the presence of the self-organized template layer 420 and the substantially strain-relaxed or unstrained GaN layer 406, which further promotes the ability of an accurate strain-engineering with the AlₓGa₁₋ₓN intermediate layer 424 in the strain-engineering sub-stack 418. That is, with the AlₓGa₁₋ₓN intermediate layer 424, it may be possible to compensate tensile strain with a compressive strain component to the GaN.

Due to accurate and precisely controlled strain-engineering, thick layer stacks and high crystal quality GaN 422 can be achieved - forming the basis for a high crystal quality active layer structure 408.

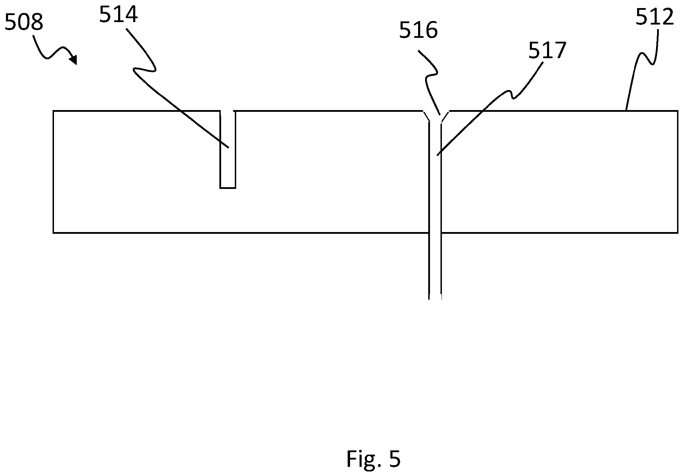

Figure 5 schematically and exemplary shows an active layer structure 508 of a semiconductor structure in a cross-sectional view. For example, the active layer structure 508 may be the active layer structure 208 or 408 of the semiconductor structure 200 or 400 described with reference to figures 2 and 4, respectively. The active layer structure 508 has nano pipes 514, 517 of which one nano pipe 517 is connected to a V-pit 516.

The nano pipes 514, 517 extend up to the upper end surface 512 of the active layer structure 508. A first nano pipe 514 extends through the active layer structure 508 and originates, e.g., in a quantum well or in a one or more multi-quantum-well structure of the active layer structure 508. It is furthermore possible that the active layer structure 508 comprises no V-pits at all. Yet, the presence of nano pipes 514, 517 may favour the formation of a V-pit as a form of strain relief at the upper end surface 512 of the active layer structure 508.

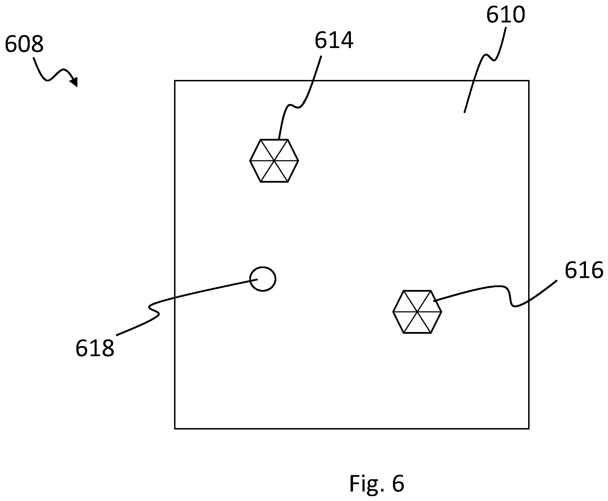

Figure 6 schematically and exemplary shows an active layer structure 608 of a semiconductor structure in a top view. For example, the active layer structure 608 may be the active layer structure 208, 408 or 508 seen in a top view. The active layer structure 608 has V-pits 614, 616 at the upper end face 610 that have a hexagonal shape in top view with {10-11} facet planes. Although the V-pits 614, 616 are shown to have a regular hexagonal shape, it is also possible that the V-pits 614, 616 have an irregular shape. One or both of the V-pits 614, 616 may be connected to a nano pipe. The active layer structure 608 also comprises a nano pipe 618 which is not connected to a V-pit and which extends through the active layer structure 608 up to the upper end face 610.

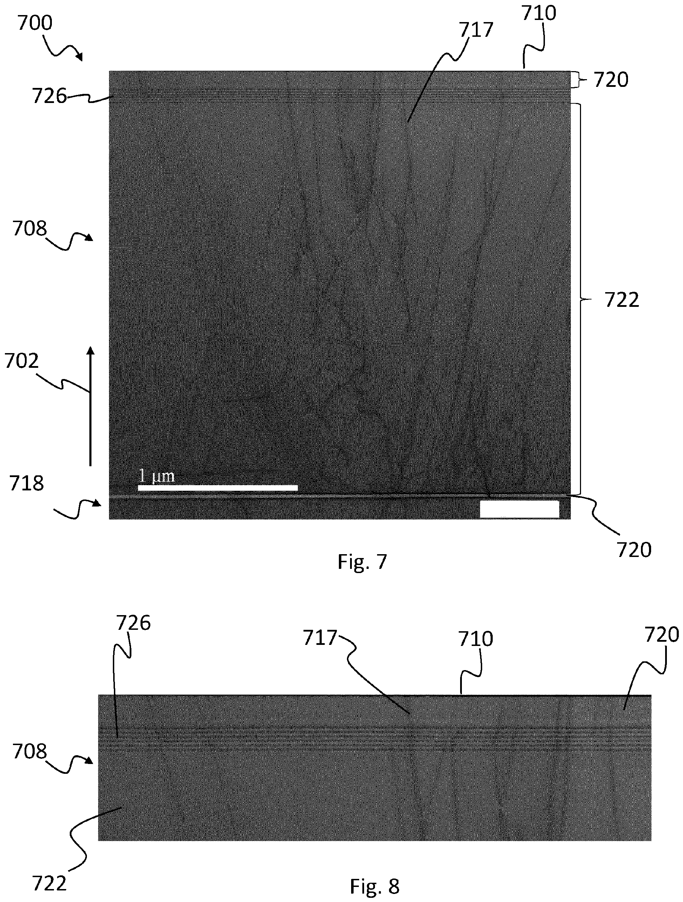

Figure 7 shows a cross-sectional transmission electron microscopy (TEM) micrograph depicting along a stacking direction 702 of a semiconductor structure 700 an AlGaN interlayer 720 of a strain-engineering sub-stack 718 as well as an n-doped GaN layer 722, a multi-quantum-well structure 726 and a p-doped GaN layer 720 of an active layer structure 708.

Figure 8 shows a cross-sectional transmission electron microscopy micrograph of an excerpt of the semiconductor structure shown in figure 7. The excerpt depicts parts of the active layer structure 708 comprising the multi-quantum-well structure 726.

As can be seen in figure 7 and also in figure 8, the GaN-on-Si epiwafer 700 is free of nano pipes, in particular, at the upper end face surface 710 of the active layer structure 708. Still, there are several threading dislocations 717 present in the GaN-on-Si epiwafer 700.

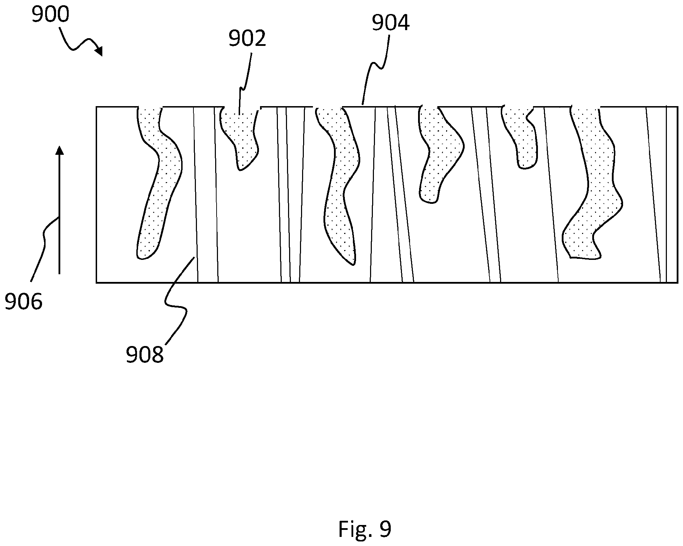

Figure 9 schematically and exemplary shows a self-organized template layer 900 in a cross-sectional view. The self-organized template layer 900 can be the self-organized template layer 420 of the semiconductor structure 400 described with reference to figure 4.

The self-organized template layer 900 comprises a plurality of template pits 902. An individual template pit 902 forms a recess in the template surface 904 of the self-organized template layer 900. The template pits 902 may have a depth of at least 7 nm and can extend up to 50 nm or even further into the self-organized template layer 900.

Some of the template pits 902 extend from the template surface 904 into the self-organized template layer 900. A fraction of template pits 902 of the self-organized template layer 900 may be allowed to fully penetrate the self-organized template layer 900 along its thickness.

The template pits 902 in the self-organized template layer 900 may have a template pit size of 1 nm to 100 nm, preferably, of 10 nm to 50 nm, in particular of 10 nm to 30 nm. The template pit size refers to a lateral extension of the template pits perpendicular to the stacking direction 906, e.g., of an opening at the template surface 904 of the self-organized template layer 900 that faces away from the substrate. A pit size of 1 nm to 100 nm is preferred for providing a self-organized template comprising template pits 902 that can be overgrown by the subsequent layer.

Preferably, the template pits 902 of the self-organized template layer 900 have an average template pit distance between adjacent template pits that is in the range of 200 nm to 2000 nm, preferably, of 200 nm and 1000 nm, e.g., of 200 nm, 500 nm, 1000 nm or 2000 nm. In particular, the template pit distance between adjacent template pits may be determined by measuring the distance from the centre of one template pit to the centre of a directly adjacent neighbouring template pit. The average template pit distance between adjacent template pits may be calculated by determining the individual distances between neighbouring template pits and then taking the average of the collected distances. An average template pit distance between adjacent pits that is in the range of 200 nm to 2000 nm is preferred since it provides a self-organized template layer 900 on which the template pits 902 can be overgrown by the subsequent epitaxial layer.

The template pits 902 of the self-organized template layer 900 may be created, e.g., due to columnar growth of the material of the self-organized template layer 900, e.g., AIN. The columnar growth of the self-organized template layer 900 can be controlled by adjusting the growth conditions applied during growth of the self-organized template layer 900. Columnar growth of the self-organized template layer 900 was found to work particular well, if the self-organized template layer 900 is an Al-containing nitride layer, and in particular an AIN-layer. This is because of the comparatively low surface migration of Al atoms, e.g., in comparison to Ga atoms. It is thus particularly the presence of Al atoms in the self-organized template layer 900 that promotes a columnar growth of the self-organized template layer 900 and a formation of template pits 902 with a pit density of 1×10⁷ cm⁻² to 1×10¹¹ cm⁻². The columnar growth is self-organized without the involvement of any structuring, e.g., masking, such that also the template pits form self-organized during the columnar growth.

Additionally to template pits 902, the self-organized template layer 900 comprises a plurality of threading dislocations 908 having a threading dislocation density of 10⁹ cm⁻² or more. The dislocations 908 comprise line defects of which at least 70% may have an angle with respect to the stacking direction 906 of 0 degrees to 5 degrees. The dislocations 908 are distributed within the complete volume of the self-organized template layer 900 whereas the template pits 902 extend from the template surface 904 into the volume of the self-organized template layer 900.

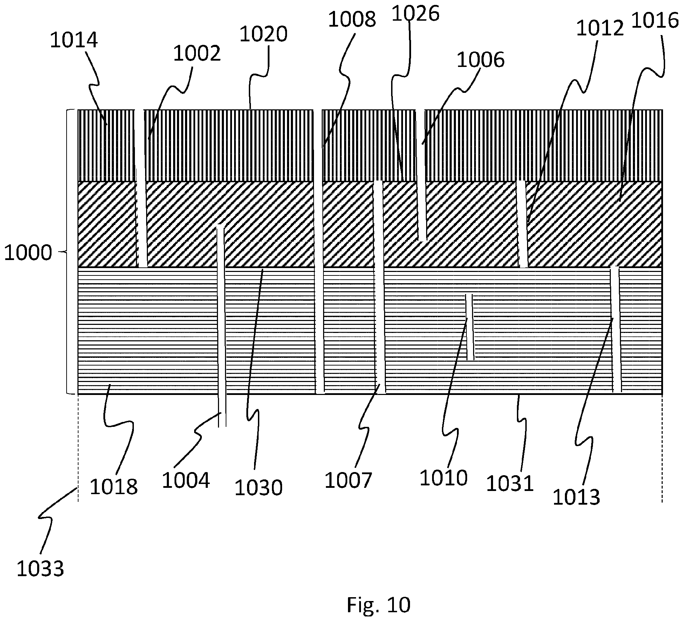

Figure 10 schematically and exemplary shows an active layer structure 1000 comprising several nano pipes 1002, 1004, 1006, 1007, 1008, 1010, 1012, 1013 that are arranged at different positions within the active layer structure 1000. In particular, figure 10 serves for exemplary depicting at which locations within the active layer structure 1000 a nano pipe 1002, 1004, 1006, 1007, 1008, 1010, 1012, 1013 may occur. However, the positions shown are not to be understood as being conclusive and nano pipes may generally be present also at other positions in the active layer structure that are not shown in figure 10. Generally, as will be explained also in the context of the detailed description further below, a nano pipe 1002, 1004, 1006, 1007, 1008, 1010, 1012, 1013 may occur due to accidental growth mechanisms, in specific growth modes, or due to doping (Si, O, Mg) or impurity segregation, be it at layer interface or within a given layer or below the active layer structure 1000. A nano pipe 1002, 1004, 1006, 1007, 1008, 1010, 1012, 1013 is configured as a hollow core that generally is unfilled and may be covered by the material applied on top, e.g. the material of a subsequent layer (deposited in-situ or ex-situ).

The active layer structure 1000 comprises a p-doped layer 1014, a multi-quantum-well structure 1016 and a n-doped layer 1018. The individual quantum wells of the multi-quantum-well structure 1016 are not visualized. The active layer structure 1000 can thus be used as an LED or for fabricating one or more LEDs, e.g., a plurality of micro LEDs. The multi-quantum-well structure 1016 and the p-doped layer 1014 form an upper interface 1026. The multi-quantum-well structure 1016 and the n-doped layer 1014 form a lower interface 1030.

The active layer structure 1000 has an upper end face 1020 up to which three nano pipes 1002, 1006, 1008 exemplary extend. A first nano pipe 1004 of the three nano pipes originates at the lower interface 1030 formed between the n-doped layer 1018 and the multi-quantum-well structure 1016 and extends up to the upper end face 1020. The other nano pipe 1006 of the three nano pipes originates in the multi-quantum-well structure 1016 and extends through the p-doped layer 1014 up to the upper end face 1020. The further nano pipe 1008 of the three nano pipes originates at the interface 1031 formed between the active layer structure 1000 and a layer 1033 below the active layer structure 1000 and extends through the active layer structure 1000 up to the upper end face 1020.

The origin of the nano pipe 1004 lies below the active layer structure 1000 within the layer 1033 below the active layer structure 1000. The nano pipe 1004 extends through the n-doped layer 1018 and terminates within the multi-quantum-well structure 1016. The nano pipe 1007 originates at the interface 1031 and extends through the n-doped layer 1018 and the multi-quantum-well structure 1016 up to the upper interface 1026. The nano pipe 1010 originates and terminates within the n-doped layer 1018. Nano pipe 1012 extends from the lower interface 1030 up to the upper interface 1026. Nano pipe 1013 extends from the interface 1031 formed between the active layer structure 1000 and the layer 1033 below the active layer structure 1000 up to the lower interface 1026. While the nano pipes 1002, 1004, 1006, 1007, 1008, 1010, 1012, 1013 are shown to extend substantially along the stacking, it is possible that one or more of the nano pipes 1002, 1004, 1006, 1007, 1008, 1010, 1012, 1013 run at an inclined angle of +/- 45° with respect to the stacking direction. One or more of the nano pipes 1002, 1004, 1006, 1007, 1008, 1010, 1012, 1013 may terminate in a V-pit.

In summary, the present invention relates to a method of fabricating a semiconductor structure and to a semiconductor structure. The present invention also relates to an optoelectronic device such comprising the semiconductor structure. Moreover, the present invention relates to a micro LED. The invention provides a semiconductor structure with a low nano pipe density of 0.1 µm⁻² or less, which may significantly contribute to realising electronic and optoelectronic devices with improved performance and reduced leakage currents.

In particular, thus, the present invention provides an epitaxial active layer structure extending from a lower end face to an upper end face opposite the lower end face. The active layer structure has a nano pipe density of 0.1 µm⁻² or less, wherein the nano pipe density denotes a density of screw-type or mixed type dislocations having a hollow open core. The epitaxial layer may be a free-standing layer structure that is suitable for mounting on a foreign substrate e.g., for fabrication of an electronic or optoelectronic device.

Other variations to the disclosed embodiments can be understood and effected by those skilled in the art in practicing the claimed invention, from a study of the drawings, the disclosure, and the appended claims.

In the claims, the word "comprising" does not exclude other elements or steps, and the indefinite article "a" or "an" does not exclude a plurality.

Any reference signs in the claims should not be construed as limiting the scope.

## Claims

1. A method of fabricating a semiconductor structure, the method comprising:
- providing a hetero-substrate, hereinafter called substrate;
- epitaxially fabricating above the substrate a substantially strain-relaxed or unstrained GaN layer; and
- epitaxially fabricating an active layer structure above the GaN layer, the active layer structure extending along a stacking direction from a lower end face facing towards the substantially strain-relaxed or unstrained GaN layer to an upper end face opposite the lower end face; wherein
- at a distance that is between 200 nm above the substrate along the stacking direction and the upper end face of the active layer structure, the semiconductor structure has a nano pipe density of 0.1 µm⁻² or less, wherein the nano pipe density denotes a density of screw-type or mixed type dislocations having a hollow open core, hereinafter called nano pipes.

2. The method according to claim 1, wherein the substantially strain-relaxed or unstrained GaN layer is fabricated to have a threading dislocation density of 1 × 10⁹ cm⁻² or less.

3. The method according to claim 1 or 2, further comprising
- epitaxially fabricating, directly on the substantially strain-relaxed or unstrained GaN layer, a strain-engineering sub-stack; wherein fabricating the strain-engineering sub-stack includes
- fabricating at least one GaN layer and at least one AlₓGa₁₋ₓN intermediate layer, x ≥ 0.5, the GaN layer having a thickness of 0.5 µm to 4.0 µm and the AlₓGa₁₋ₓN intermediate layer having a thickness of 5 nm to 25 nm.

4. The method according to at least one of the preceding claims, comprising
- epitaxially growing on the substrate a self-organized template layer having a template pit density of 1×10⁷ cm⁻² to 1×10¹¹ cm⁻²; and
- fabricating the substantially strain-relaxed or unstrained GaN layer directly on the self-organized template layer.

5. The method according to at least one of the preceding claims, comprising
- thinning the semiconductor structure starting from a backside of the semiconductor structure up to the active layer structure such that the active layer structure remains, and
- fabricating an electronic or an optoelectronic device from the remaining active layer structure, the optoelectronic device being configured to emit light under electrical or optical excitation.

6. A semiconductor structure, the semiconductor structure comprising along a stacking direction:
- a hetero-substrate, hereinafter called, substrate,
- a substantially strain-relaxed or unstrained GaN layer arranged above the substrate, and
- an epitaxial active layer structure arranged above the GaN layer arranged above the GaN layer along the stacking direction and extending along the stacking direction from a lower end face facing towards the GaN layer to an upper end face opposite the lower end face, wherein
at a distance that is between 200 nm above the substrate along the stacking direction and the upper end face of the active layer structure, the semiconductor structure has a nano pipe density of 0.1 µm⁻² or less, wherein a nano pipe density denotes a density of screw-type or mixed type dislocations having an open core, hereinafter called nano pipes.

7. The semiconductor structure according to claim 6, wherein at each distance that is between 200 nm above the substrate along the stacking direction and the upper end face of the active layer structure, the semiconductor structure has a nano pipe density of 0.1 µm⁻² or less.

8. The semiconductor structure according to claim 6 or 7, wherein at a distance that is between 200 nm above the substrate along the stacking direction and the lower end face of the active layer structure, the semiconductor structure has a nano pipe density of 0.1 µm⁻² or less.

9. The semiconductor structure according to at least one of claims 6 to 8, wherein at least 80 % of the nano pipes, if present, extend substantially along the stacking direction.

10. The semiconductor structure according to at least one of claims 6 to 9, having a nano pipe density of 0.1 µm⁻² or less at a distance that is between the upper end face of the active layer structure and at least 1 µm below the upper end face.

11. The semiconductor structure according to at last one of claims 6 to 10, wherein at least 80 % of the nano pipes, if present, have a diameter of 0.6 nm to 100 nm.

12. The semiconductor structure according to claim 6 to 11, wherein the active layer structure includes a quantum well of a III-nitride material and/or a transistor structure.

13. The semiconductor structure according to at least one of the claims 6 to 12, wherein the substantially strain-relaxed GaN layer has an in-plane and/or an out-of-plane lattice parameter that differs no more than 5 % from the respective in-plane and/or an out-of-plane bulk lattice parameters.

14. An electronic device comprising an active layer structure that has a nano pipe density of 0.1 µm⁻² or less, wherein a nano pipe density denotes a density of screw-type or mixed type dislocations having an open core, hereinafter called nano pipes, the active layer structure comprising a transistor structure.

15. An optoelectronic device comprising an active layer structure that has a nano pipe density of 0.1 µm⁻² or less, wherein a nano pipe density denotes a density of screw-type or mixed type dislocations having an open core, hereinafter called nano pipes, the optoelectronic device being configured as a micro LED, wherein the active layer structure comprising the quantum well is configured to emit electromagnetic radiation in a wavelength range of 400 nm to 800 nm or that is configured to emit electromagnetic radiation in a wavelength range of 200 nm to 400 nm.
